# FASCICULE DE BREVET EUROPEEN

(11) **EP 1 580 805 B1**
(45) Date de publication et mention de la délivrance du brevet: **19.06.2013**
(21) Numéro de dépôt: 05102319.0
(22) Date de dépôt: 23.03.2005
(51) Int. Cl.: H01L 21/02, H01L 21/20, H01L 21/316, H01L 21/762

(54) **Procédé de préparation d'une couche de dioxide de silicium par oxidation à haute temperature sur un substrat présentant au moins en surface d'un alliage silicium-germanium**
Verfahren zum Präparieren einer Siliziumoxidschicht durch Oxidation bei hohe Temperatur auf einem Substrat mit einer Silizium-Germanium Oberfläche
Process for preparing a silicon dioxide layer by high temperature oxidation of a substrate having at least a silicon-germanium surface

(30) Priorité: 25.03.2004 FR 0450590
(43) Date de publication de la demande: 28.09.2005
(73) Titulaire: Commissariat à l'Énergie Atomique et aux Énergies Alternatives, 75015 Paris (FR)
(72) Inventeur: Moriceau, Hubert, 38120, Saint Egrève (FR); Mur, Pierre, 38920, Crolles (FR)
(74) Mandataire: Ahner, Philippe

(56) Documents cités:
- EP-A- 0 435 135
- WO-A-03/036698
- WO-A-03/092058
- FR-A- 2 842 349
- JP-A- 62 136 036
- US-A- 5 882 987
- US-A1- 2003 230 778
- US-B1- 6 350 993
- US-B1- 6 673 696

## Description

### DOMAINE TECHNIQUE

L'invention concerne un procédé de préparation d'une couche ou film d'oxyde de silicium par oxydation à haute température (silice thermique) sur un substrat présentant au moins en surface du germanium ou un alliage silicium-germanium ; plus particulièrement sur un substrat de germanium ou d'alliage silicium-germanium.

L'oxydation du germanium et des alliages silicium-germanium, répondant à la formule GeₓSi₁₋ₓ avec x > 0 et x ≤ 1 revêt depuis quelques années une importance croissante.

En effet, le germanium et les alliages Ge-Si ont des propriétés électroniques et optiques intéressantes et fournissent des hétérostructures notamment pour divers dispositifs semiconducteurs à base de silicium.

Or, pour les technologies impliquant le germanium ou les alliages Si-Ge, les propriétés de l'oxyde formé par ce matériau sont critiques.

Le domaine technique de l'invention peut ainsi, de manière générale, être défini comme celui de l'oxydation, plus précisément de l'oxydation à haute température, à savoir typiquement supérieure à 400°C, du Ge ou du SiGe afin de réaliser un film d'oxyde à la surface dudit Ge ou SiGe.

Les procédés classiques d'oxydation du silicium ont été testés pour oxyder les alliages Si₁₋ₓGeₓ. On distingue de manière générale les procédés d'oxydation par voie sèche ("dry" en anglais) et les procédés d'oxydation par voie humide qui mettent en oeuvre de la vapeur d'eau ("steam" en anglais). Ces procédés ont été essayés dans de larges plages de températures, supérieures à 500°C, et l'oxydation a été étudiée en fonction du temps de traitement à haute température et en ce qui concerne la vitesse d'oxydation obtenue.

L'article général de L.S. RILEY et S. HALL, Journal of Applied Physics, volume 85, n°9, 1er mai 1999, p. 6828-6837 fournit un récapitulatif assez exhaustif des procédés d'oxydation de Si₁₋ₓGeₓ (voir tableau I dudit document).

On observe pour la plupart de ces procédés une ségrégation non souhaitable du germanium dès lorsque le traitement est réalisé à une température de plus de 500°C.

Par ailleurs, le document de W.S. LIU et al., J. Appl. Phys. 71(7), 1er avril 1992, p. 3626-3627 décrit l'oxydation thermique par voie humide à 1000°C d'une couche épitaxiale de Ge_{0,36}Si_{0,64} de 470 nm d'épaisseur sur du Si (100) et met en évidence que le procédé produit des oxydes de différentes compositions en fonction des conditions du procédé d'oxydation.

Ainsi, quand un échantillon sans préchauffe est directement exposé à la vapeur chaude, la couche de surface contient à la fois du Ge et du Si, tandis que seulement du SiO₂ se forme si un échantillon préchauffé est exposé à la vapeur chaude, avec une concentration accrue du germanium en front d'oxydation ; de tels effets ne sont pas présents lorsqu'on effectue une oxydation sèche.

Le document de W.S. LIU et al., J. Appl. Phys. 71(8), 15 avril 1992 décrit l'oxydation par voie humide de GeSi (couches de 500 nm d'épaisseur de Ge_{0,36}Si_{0,64} et Ge_{0,28}Si_{0,72} sur Si (100)) à 700°C. Une couche uniforme d'oxyde GeₓSi₁₋ₓO₂ se forme avec une interface lisse avec la couche sous-jacente de GeₓSi₁₋ₓ.

L'oxydation du SiGe n'est qu'une oxydation partielle, il y a donc une présence uniforme de germanium dans l'oxyde formé et celui-ci est un oxyde "mixte" Si₁₋ₓGeₓO₂ et non SiO₂ qui est l'oxyde recherché dans la présente.

Les mêmes auteurs W.S. LIU et al. ont étudié dans le document J. Appl. Phys. 72(9), 1er novembre 1992, p. 4444-4446 l'oxyde formé par oxydation partielle dans le document précédent et ils ont mis en évidence son instabilité lors de traitements de recuit à 900°C pendant 3 heures, de vieillissement à l'air à température ambiante pendant 5 mois, et d'immersion dans l'eau.

Le document US-B1-6 352 942 est relatif à un procédé de préparation d'une couche de haute qualité de dioxyde de silicium sur une couche de germanium, dans lequel on dépose une couche de silicium sur la couche de germanium puis on oxyde cette couche pour donner une couche de SiO₂.

L'oxydation de la couche de silicium peut être réalisée par voie sèche, c'est-à-dire en exposant la couche de Si à de l'oxygène gazeux sec à une température d'au moins 500°C, de préférence sous pression, ou bien par voie humide en exposant la couche de Si à de la vapeur d'eau à une température d'au moins 500°C, de préférence sous pression.

La technique décrite dans le document US-B1-6 352 942 nécessite un contrôle délicat de l'arrêt de l'oxydation.

Par ailleurs, si la couche de Si est épitaxiée, elle ne peut être très fine, étant donné la différence de paramètre de maille qui existe entre Si et Ge.

Si au contraire, la couche de Si est déposée, sous forme de Si amorphe ou polycristallin, il est alors difficile de contrôler la qualité de l'interface avec le Ge.

De plus, avec cette technique, il y a une diffusion non contrôlée du Ge dans le Si.

Le document WO-A2-03/036698 décrit un procédé pour déposer au moins une couche épitaxiale de SiGe sur un substrat en SiGe comprenant tout d'abord le dépôt d'une couche germe en Si sur le substrat en SiGe et puis le dépôt de la couche épitaxiale de SiGe sur la couche germe en Si.

Le document JP 62-136036 décrit un procédé de formation de film isolant, dans lequel un film constitué de silicium et de germanium est déposé sur un substrat de germanium et soumis à un traitement thermique sous atmosphère oxydante.

Il apparaît au vu de l'étude de l'art antérieur qui précède que la possibilité de générer un oxyde de silicium de bonne qualité se heurte toujours actuellement essentiellement à deux problèmes :
- La qualité des surfaces de plaques, couches, ou films de germanium ou d'alliages SiGe à très forte concentration de Ge se dégrade lorsqu'ils sont traités thermiquement dans une atmosphère oxydante, et il y a formation d'oxyde de germanium, qui est connu pour son instabilité, et non uniquement de SiO₂.
- Lors du traitement thermique de plaques, couches, films de silicium-germanium dans une atmosphère oxydante, on cherche à provoquer l'oxydation du silicium situé à proximité de la surface. Si l'on parvient à obtenir un oxyde exempt de germanium ce qui permet d'éviter les problèmes liés à la formation d'oxyde de germanium mentionnés ci-dessus, cela s'explique en particulier par une migration du germanium qui se traduit par une augmentation non contrôlée de la concentration en germanium en "avant" du front d'oxydation. Le gradient non contrôlé de concentration en germanium ainsi obtenu en avant du front d'oxydation n'est pas acceptable pour la plupart des applications ultérieures visées telles que par exemple la microélectronique haute fréquence.

Il existe donc un besoin pour un procédé de préparation d'une couche d'oxyde de silicium par oxydation à haute température, sur un substrat de germanium ou d'alliage silicium-germanium, qui ne présente pas les inconvénients, défauts, limitations et désavantages des procédés de l'art antérieur.

Il existe en particulier un besoin pour un procédé de préparation d'une couche d'oxyde de silicium par oxydation à haute température, sur un substrat de germanium ou d'alliage silicium-germanium qui évite la formation d'oxyde de germanium instable, et qui par ailleurs, selon l'application visée, évite ou contrôle la migration du germanium, la ségrégation du germanium et l'apparition de gradients de concentration en germanium au voisinage de l'interface entre le SiO₂ et le substrat par exemple en Si₁₋ₓGex.

Il existe de manière générale, un besoin pour un tel procédé qui assure la formation d'une interface SiO₂-substrat (par exemple Si₁₋ₓGeₓ) d'excellente qualité.

Ce besoin, et d'autres encore, sont atteints, conformément à l'invention selon revendication 1 par un procédé de préparation d'une couche de dioxyde de silicium, par oxydation à haute température, sur un substrat de formule Si₁₋ₓGeₓ dans laquelle x est supérieur à 0 et inférieurà 1, ledit procédé comprenant les étapes successives suivantes :
a) on dépose sur ledit substrat de formule Si₁₋ₓGeₓ au moins une couche supplémentaire d'épaisseur h_{y} et de formule globale Si_{1-y}Ge_{y} dans laquelle y est supérieur à 0 et inférieur à x ;
b) on réalise l'oxydation à haute température de ladite couche supplémentaire de formule globale Si_{1-y}Ge_{y}, moyennant quoi ladite couche supplémentaire est transformée en totalité ou en partie en une couche d'oxyde de silicium SiO₂.

Par oxydation à haute température, on entend généralement que l'oxydation est réalisée à une température qui soit suffisante pour provoquer l'oxydation de la (des) couche(s) supplémentaire(s) (et de la couche complémentaire éventuelle voir plus loin) essentiellement sous l'action de l'énergie thermique. Cette température est généralement supérieure ou égale à 400°C.

Le procédé de l'invention est essentiellement caractérisé en ce que l'on dépose, en surface, sur le substrat de formule Si₁₋ₓGeₓ au moins une couche supplémentaire d'épaisseur h_{y} et de formule globale Si_{1-y}Ge_{y}. Par formule "globale", on entend la formule moyenne présentée par la couche en retenant la valeur moyenne de y pour l'ensemble de la couche, obtenue à partir des différentes valeurs de y mesurées par exemple à diverses épaisseurs.

Une telle étape de dépôt d'une couche supplémentaire de Si_{1-y}Ge_{y} n'est ni décrite, ni suggérée dans l'art antérieur.

Ainsi, dans le document US-B1-6 352 942 une couche que l'on peut qualifier de "couche supplémentaire" est elle déposée mais il s'agit d'une couche de silicium et non d'alliage de silicium germanium de composition particulière.

L'étape b) du procédé selon l'invention peut être définie comme une étape de réalisation d'un film supplémentaire, sacrificiel et spécifique d'alliage silicium-germanium de formule Si_{1-y}Ge_{y}.

Cette couche est une couche supplémentaire au regard de la plupart des procédés de l'art antérieur dans lesquels la structure à oxyder se termine en surface par un matériau, qu'il s'agisse d'un substrat ou d'un film, de composition Si₁₋ₓGeₓ.

Conformément à l'invention, cette couche est une couche spécifique, car sa composition, définie par y, et son épaisseur initiales (h_{y}) sont choisies en fonction du substrat, support, sur lequel on la réalise, pour obtenir une concentration spécifique et contrôlée de germanium en amont de la couche de SiO₂.

Cette couche est sacrificielle, en ce sens que sur tout ou partie de son épaisseur elle va servir à la génération de l'oxyde de silicium.

Le procédé selon l'invention, grâce essentiellement au dépôt de la couche supplémentaire lors de l'étape b), ne présente pas les inconvénients, défauts, limitations et désavantages des procédés de l'art antérieur et résout les problèmes des procédés de l'art antérieur.

En particulier, selon l'invention, on obtient à l'issue de l'oxydation de la couche supplémentaire une interface de grande qualité entre d'une part le Si₁₋ₓGeₓ, ou le Si_{1-z}Ge_{z} formé dans la couche Si_{1-y}Ge_{y} (voir plus loin), et d'autre part, l'oxyde de silicium formé.

En outre, on peut également, par un choix adapté de la couche supplémentaire Si_{1-y}Ge_{y}, obtenir une concentration en germanium, au voisinage de l'interface avec l'oxyde de silicium, sensiblement constante, sans ségrégation du germanium et sans augmentation de sa concentration près de l'interface. On obtient alors en surface du substrat, du Si₁₋ₓGeₓ muni d'une couche de SiO₂. Pour cela, on dépose une couche supplémentaire Si_{1-y}Ge_{y}, y étant choisi de sorte qu'après oxydation une partie de cette couche supplémentaire est consommée, le reste de la couche étant transformé en Si₁₋ₓGeₓ.

On peut a contrario, si on le souhaite, toujours en choisissant une couche supplémentaire adaptée, obtenir une concentration contrôlée de germanium, différente de x, en amont de l'oxyde (c'est-à-dire dans une couche de Si_{1-z}Ge_{z} entre le Si₁₋ₓGeₓ et la couche d'oxyde, z pouvant être selon les cas inférieur ou supérieur à x) tout en maîtrisant parfaitement l'épaisseur d'oxyde créée.

En d'autres termes, suite à l'oxydation :
- soit Si_{1-y}Ge_{y} est oxydé en totalité : on a alors une couche de SiO₂ sur le Si₁₋ₓGeₓ dont la composition présente un front de Ge contrôlé (on a alors une couche de Si_{1-x'}Geₓ, avec x'>x en surface de Si₁₋ₓGeₓ) ;
- soit Si_{1-y}Ge_{y} est oxydé en partie : on a alors une couche de SiO₂ sur Si_{1-z}Ge_{z} sur Si₁₋ₓGeₓ avec z>y ; et avantageusement, on fait en sorte que z=x.

Par ailleurs, l'oxyde formé par le procédé de l'invention est un oxyde simple de silicium exempt d'oxyde de germanium et non un oxyde mixte.

Donc, conformément à l'invention y et/ou h_{y} sont choisies pour contrôler à l'issue de l'oxydation la concentration du germanium de la couche d'alliage SiGe se trouvant sous la couche d'oxyde de silicium.

Conformément à l'invention, la composition de la couche supplémentaire définie par y, et/ou l'épaisseur h_{y}, est (sont) choisie(s) en fonction du substrat Si₁₋ₓ Geₓ, et/ou de l'épaisseur de la couche d'oxyde de silicium SiO₂ et/ou de la concentration en germanium de la couche d'alliage de silicium-germanium se trouvant immédiatement sous la couche d'oxyde de silicium.

Avantageusement, la composition de la couche supplémentaire définie par y, et/ou l'épaisseur h_{y}, est (sont) choisie(s) de façon à limiter les contraintes générées par la différence des mailles cristallines entre Si₁₋ₓGeₓ et Si_{1-y}Ge_{y}.

Avantageusement, lors de l'étape b), ladite couche supplémentaire, est transformée en partie en oxyde de silicium, pour donner une couche d'oxyde de silicium, sur une couche de formule Si_{1-z}Ge_{z} et d'épaisseur h_{z}.

Avantageusement, z est sensiblement égal à x.

La couche supplémentaire peut être une couche à gradient de composition dans laquelle la concentration en germanium varie de manière continue, de préférence décroît de manière continue, à partir du substrat.

On peut déposer plusieurs couches supplémentaires, qui diffèrent par leur valeur de y, la valeur de y décroissant de préférence depuis la couche supplémentaire située au voisinage du substrat jusqu'à la couche située à l'épaisseur h_{y}.

Il est possible que l'on on dépose en outre une couche complémentaire de SiGe sur ladite au moins une couche supplémentaire, ladite couche complémentaire étant également transformée en totalité en une couche d'oxyde de silicium SiO₂.

Ou bien on peut déposer en outre une couche complémentaire de SiO₂ sur ladite au moins une couche supplémentaire.

L'oxydation est généralement une oxydation par traitement thermique oxydant réalisé par voie sèche et/ou humide.

L'ensemble des propriétés avantageuses présentées en fin de procédé par le substrat muni de sa couche de SiO₂ rendent son utilisation aisée dans toutes les applications envisagées telles que par exemple, la microélectronique haute fréquence ou encore la réalisation de substrats SiGeOI ou GOI (respectivement "SiGe ou Ge on Insulator").

L'invention a trait, en outre, à un procédé de préparation de composants optiques ou électroniques (par exemple de "MOSFETS") comprenant au moins une étape dans laquelle on prépare une couche de SiO₂ par le procédé tel que défini plus haut.

L'invention concerne un procédé de préparation d'une structure Si₁₋ₓGeₓOI dans lequel dans un premier mode de réalisation on prépare une structure comprenant un film de Si₁₋ₓGeₓ recouvert d'une couche d'oxyde de silicium SiO₂ par le procédé selon l'invention décrit ci-dessus, on fragilise, avant ou après l'étape b), une couche située au sein du film de Si₁₋ₓGeₓ par exemple par implantation d'espèces gazeuses, on assemble cette structure comprenant la couche fragilisée avec un substrat, par exemple de silicium, pour obtenir un assemblage comprenant le substrat et la structure, et on dissocie cet assemblage au niveau de la couche fragilisée par un traitement thermique et/ou mécanique.

L'invention concerne un procédé de préparation d'une structure Si₁₋ₓGeₓOI dans lequel, dans un second mode de réalisation, on prépare une structure comprenant un film de Si₁₋ₓGeₓ recouvert d'une couche d'oxyde de silicium SiO₂, par le procédé selon l'invention décrit ci-dessus, on assemble cette structure avec un substrat, pour obtenir un assemblage comprenant le substrat et la structure, et on procède à l'amincissement de cet assemblage par voie mécanique et/ou chimique.

L'invention va maintenant être décrite de manière détaillée dans la description qui suit, en relation avec les dessins joints dans lesquels :

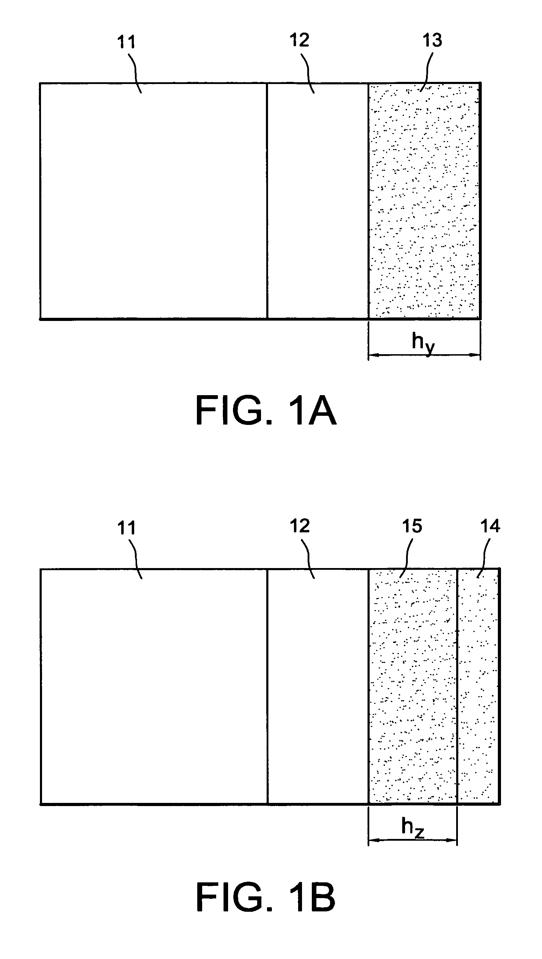

- Les figures 1A et 1B illustrent un premier mode de réalisation du procédé selon l'invention dans lequel est déposé sur le substrat un film, couche supplémentaire présentant la formule Si_{1-y}Ge_{y} qui fournit par oxydation un film enrichi en Ge de formule Si_{1-z}Ge_{z}, et un film de SiO₂.

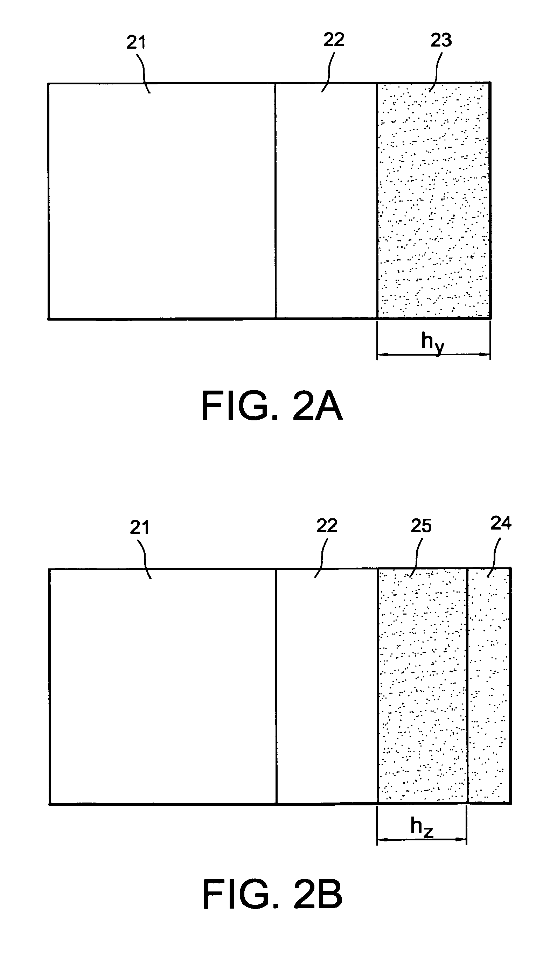

- Les figures 2A et 2B illustrent un deuxième mode de réalisation du procédé selon l'invention dans lequel est déposé sur le substrat un film, couche, supplémentaire qui est un film à gradient de composition Si_{1-grad y}Ge_{grad y} qui fournit par oxydation un film enrichi en Ge de formule Si_{1-grad z}Ge_{grad z} et un film de SiO₂.

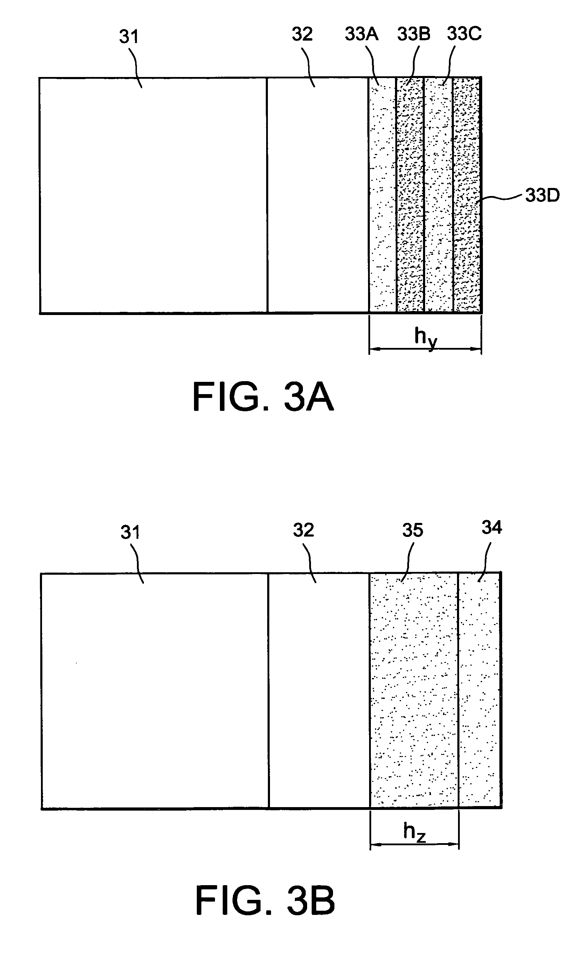

- Les figures 3A et 3B illustrent un troisième mode de réalisation du procédé selon l'invention dans lequel plusieurs films, couches, supplémentaires possédant les formules Si_{1-y}Ge_{y}, avec différentes valeurs de y sont déposées sur le substrat ; et ces couches fournissent par oxydation un film enrichi en Ge de formule Si_{1-z}Ge_{z}, et un film de SiO₂.

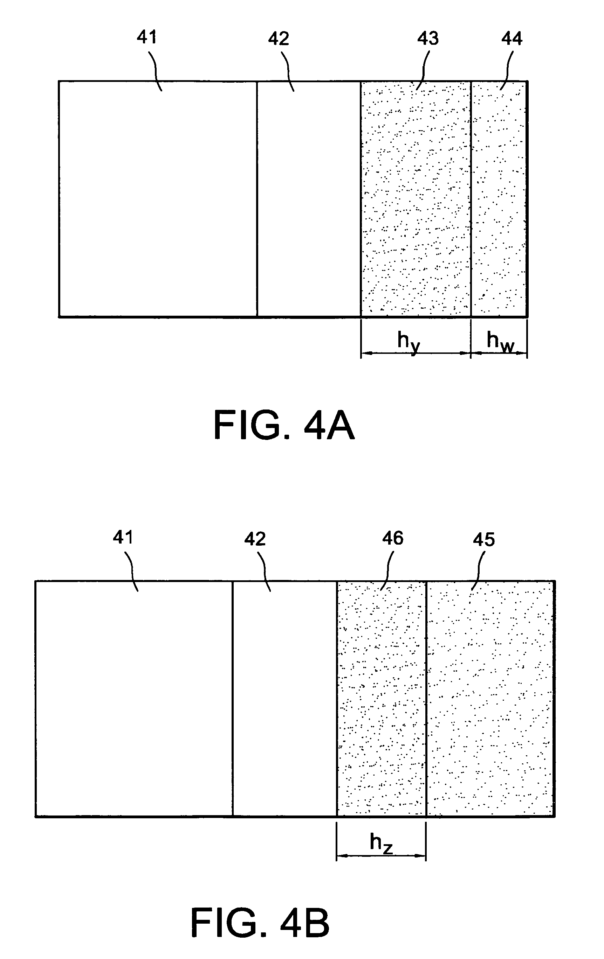

- Les figures 4A et 4B illustrent un quatrième mode de réalisation du procédé selon l'invention dans lequel on dépose en outre un film, couche, complémentaire par exemple de formule Si_{1-w}Ge_{w}, sur le film supplémentaire Si_{1-y}Ge_{y} ; lors de l'oxydation un film enrichi en Ge de formule Si_{1-z}Ge_{z} est généré dans le film supplémentaire et un film d'oxyde SiO₂ est généré dans les films complémentaire et supplémentaire.

Le procédé de l'invention est un procédé de préparation, par oxydation à haute température, d'une couche de dioxyde de silicium sur un substrat, ledit substrat répondant à la formule Si₁₋ₓGeₓ.

Le substrat selon l'invention comporte généralement une surface essentiellement plane sur laquelle est préparée la couche de dioxyde de silicium.

Le substrat de Si₁₋ₓGeₓ peut être un substrat massif, notamment dans le cas où x=1, c'est-à-dire un substrat massif de germanium. Un tel substrat se présente généralement sous la forme d'un disque d'épaisseur typiquement comprise entre 300 et 900 µm.

Le substrat de Si₁₋ₓGeₓ peut également se présenter, préférentiellement, sous la forme d'une couche ou film, de préférence monocristallin, de Si₁₋ₓGeₓ (12, 22, 32, 42) généralement de 5 nm à un ou quelques microns d'épaisseur (par exemple 1, 2, 5 ou 10 µm), qui se trouve elle-même déposée sur un support (11, 21, 31, 41).

Le support (11, 21, 31, 41) peut être un support en un seul matériau (support monomatériau), par exemple du germanium ou du silicium, mais il peut s'agir d'un support composite. Ce support peut comprendre un substrat de base par exemple en silicium, sur lequel sont réalisée(s) une ou plusieurs couches tampons d'adaptation, par exemple de SiGe, par des technologies diverses et connues de l'homme du métier dans ce domaine de la technique.

La couche ou film de Si₁₋ₓGeₓ (substrat) (12, 22, 32, 42) est déposée sur le support par exemple par épitaxie ou par dépôt chimique en phase vapeur ("CVD"). Il s'agit généralement d'une couche relaxée.

Cette couche a généralement une épaisseur de un à quelques nm (par exemple 1, 2, 10 nm) à un ou quelques microns (par exemple 1, 2, 10 µm) par exemple.

Dans la formule Si₁₋ₓGeₓ, x est supérieur à 0 et inférieur ou égal à 1, cela signifie donc que le substrat peut être en germanium ou bien en alliage silicium-germanium dont la composition en germanium est strictement comprise entre 0 et 1. Par exemple, elle peut valoir 0,3.

Conformément au procédé de l'invention, (étape a)), on dépose sur le substrat de formule Si₁₋ₓGeₓ au moins une couche ou film supplémentaire de formule globale Si_{1-y}Ge_{y} et d'épaisseur h_{y} dans laquelle y est supérieur à 0 et inférieur à x. Par exemple, y peut valoir 0,25 si x vaut 0,3.

Comme on l'a déjà indiqué plus haut cette couche supplémentaire est aussi une couche spécifique car on choisit sa composition (y) et son épaisseur initiale h_{y} (avant oxydation) en fonction du substrat Si₁₋ₓGeₓ sur lequel on la réalise et/ou de l'épaisseur d'oxyde à former et/ou de la concentration en Ge en amont de cet oxyde que l'on souhaite obtenir. Avantageusement, on choisira y, pour obtenir à l'issue de l'oxydation, une concentration de germanium égale à x au voisinage de la couche d'oxyde créée.

En particulier, lors de l'élaboration de cette couche, ou film, supplémentaire, et dans la mesure où l'on veut par exemple obtenir pour ce film une qualité épitaxiale, il peut y avoir une épaisseur limite, supérieure, du film supplémentaire à respecter. En effet, les contraintes générées par la différence des mailles cristallines de Si₁₋ₓGeₓ et de Si_{1-y}Ge_{y} peuvent devenir trop importantes pour la couche ou film supplémentaire engendrant des dislocations de ladite couche supplémentaire.

En conséquence, l'épaisseur h_{y} de la couche supplémentaire ou des couches supplémentaires est choisie généralement de façon à limiter les contraintes générées par la différence des mailles cristallines entre Si₁₋ₓGeₓ et Si_{1-y}Ge_{y}. En outre, l'épaisseur initiale h_{y} de la couche ou des couches supplémentaires est choisie pour contrôler la concentration du germanium en amont de l'oxyde, c'est-à-dire la concentration en germanium de la couche d'alliage de silicium-germanium se trouvant immédiatement sous la couche d'oxyde de silicium (cette concentration peut être égale à x ou avoir une valeur plus élevée ou plus faible selon l'application visée).

L'épaisseur h_{y} de la ou des couches (épaisseur totale des couches) est généralement de un à quelques nm, par exemple de 1 à 5 ou 10 nm.

La ou les couches supplémentaires peut (peuvent) être déposée(s) par tout procédé connu de l'homme du métier dans le domaine de la technique, par exemple un procédé de dépôt chimique en phase vapeur (CVD), un procédé préféré est l'épitaxie par dépôt chimique en phase vapeur sous pression réduite (RPCVD ou "reduced pressure CVD").

On peut déposer une ou plusieurs couches supplémentaires sur le substrat.

Sur les figures 1A à 4A et 1B à 4B, le substrat comprend un support (11, 21, 31, 41) (monomatériau par exemple Ge ou composite par exemple Si avec des couches d'adaptation de SiGe) et une couche de Si₁₋ₓGeₓ relaxé (12, 22, 32, 42) avec par exemple x = 0,3, mais il est bien évident que cela n'est donné qu'à titre d'exemple illustratif.

Dans une première forme de réalisation du procédé selon l'invention illustré sur la figure 1A, on dépose une seule couche supplémentaire (13) qui a généralement une épaisseur h_{y} de 1 à quelques nm, par exemple 2, 5, ou 10 nm, cette couche (13) a une formule Si_{1-y}Ge_{y}, la valeur de y restant constante sur toute l'épaisseur de la couche (13) et étant telle que définie plus haut par exemple égale à 0,25 (Si_{0,75}Ge_{0,25}) .

Dans une deuxième forme de réalisation du procédé selon l'invention, illustré sur la figure 2A, la couche ou film supplémentaire (23) est une couche (23) à gradient de composition dans laquelle la concentration initiale (y) en germanium varie de manière continue. De préférence, cette concentration en germanium décroît de manière continue à partir du substrat et en s'éloignant de celui-ci et est minimale lorsque l'on atteint l'épaisseur h_{y}.

Par exemple, la valeur de y (y₀) peut être comprise entre 0,3 et 0,15 au voisinage du substrat, et est entre 0,25 et 0,05 à l'épaisseur h_{y} (y_{hy}), h_{y} pouvant être compris entre 1 et 10 nm.

Cela signifie que le gradient de concentration en germanium peut être par exemple un gradient décroissant depuis la surface du substrat à raison de 1 à 10 pour mille par nanomètre.

La couche supplémentaire (23), dans ce deuxième mode de réalisation peut donc être définie par la formule Si_{1-grad y}Ge_{grad y}, où donc, grad y varie de manière continue par exemple de 0,3 (au voisinage de l'interface couche supplémentaire/couche de Si₁₋ₓGeₓ) jusqu'à 0,15 (à l'épaisseur h_{y}) .

Dans une troisième forme de réalisation de l'invention, illustré sur la figure 3A, plusieurs couches supplémentaires sont déposées ; ainsi sur la figure 3A, 4 couches supplémentaires (33A, 33B, 33C, 33D) sont déposées, mais il ne s'agit là que d'un exemple.

L'épaisseur totale de ces couches (33A, 33B, 33C, 33D) est égale à h_{y} déjà défini plus haut et chaque couche peut avoir une épaisseur différente, ou avoir la même épaisseur, cette épaisseur est généralement de 1 nanomètre à quelques dizaines de nanomètres (par exemple 200 nm).

Lorsqu'il y a plusieurs couches supplémentaires ces couches diffèrent généralement par leur valeur de y. De préférence, la valeur de y décroît depuis la couche supplémentaire située au voisinage du substrat (couche 33A formant l'interface avec le substrat 32) jusqu'à la couche (la plus externe 33D) située à l'épaisseur h_{y}, depuis une valeur de y(y₀) qui est de préférence de 0,1 à 0,5 par exemple 0,3 jusqu'à une valeur de y(y_{hy}) qui est de préférence de 0,01 à 0,3, par exemple 0,2.

De préférence, la valeur de y diminue d'un même pas ou incrément Δy entre chaque couche supplémentaire parmi plusieurs couches supplémentaires.

Sur la figure 3A où l'on a déposé 4 couches supplémentaires, y varie par exemple de 0,275 (y₀) pour la couche 33A au voisinage du substrat jusqu'à 0,200 (y_{hy}) pour la couche 33D la plus externe, avec un pas, incrément Δy de 0,25. Les 4 couches auront donc des valeurs de y de 0,275 ; 0,250 ; 0,225 ; et 0,200.

Dans une quatrième forme de réalisation, on dépose en outre une couche dite "complémentaire" sur la ou les couches supplémentaires. Ainsi, sur la figure 4A, on a déposé une couche complémentaire (44) par exemple d'épaisseur h_{w}, sur la couche supplémentaire (43). La couche complémentaire peut être également transformée, en totalité, en une couche d'oxyde de silicium SiO₂. En variante, elle peut être directement un oxyde (SiO₂) déposé par exemple par LPCVD.

Cette couche complémentaire est intéressante par exemple dans le cas où l'on souhaite obtenir une épaisseur d'oxyde supérieure à celle qu'autorise l'épaisseur critique correspondant à la composition de la ou des couches supplémentaires. Avantageusement, cette couche pourra être en SiGe par exemple de formule Si_{1-w}Ge_{w}. Cette couche, qui sera totalement transformée en une couche d'oxyde, n'a pas besoin d'avoir une bonne qualité cristalline : elle peut être polycristalline, amorphe ou encore monocristalline à forte densité de dislocations.

Une fois que la ou les couches supplémentaires et la couche complémentaire éventuelle ont été déposées sur le substrat de Si₁₋ₓGeₓ on procède à l'oxydation à haute température de ladite ou desdites couche (s) supplémentaire (s) de formule globale Si_{1-y}Ge_{y}, moyennant quoi ladite ou lesdites couche(s) supplémentaire(s) et éventuellement ladite couche complémentaire éventuelle est (sont) transformée(s) en totalité ou en partie en oxyde de silicium SiO₂ ou plus précisément en couche d'oxyde de silicium SiO₂.

L'oxydation est réalisée à haute température, comme précédemment défini, typiquement supérieure à 400°C. L'oxyde SiO₂ formé est défini comme du SiO₂, de la silice, "thermique".

L'oxydation peut être une oxydation par voie sèche. Dans ce cas, l'oxydation est généralement réalisée en mettant en contact la (les) couche(s) supplémentaire(s) et la couche complémentaire éventuelle, avec un gaz oxydant sec par exemple de l'oxygène.

Ou bien, l'oxydation peut être une oxydation par voie humide, c'est-à-dire que l'on met en contact la couche supplémentaire et la couche complémentaire éventuelle avec un gaz contenant de la vapeur d'eau, tel qu'un mélange de vapeur d'eau, d'hydrogène, et d'oxygène.

Sous l'effet de l'oxydation à haute température, la couche supplémentaire de formule globale Si_{1-y}Ge_{y} et d'épaisseur h_{y} est transformée en totalité ou en partie en une couche d'oxyde de silicium.

Il est à noter que dans le cas où une couche complémentaire est présente, celle-ci, si elle n'est pas déjà en oxyde de silicium, est transformée en totalité en oxyde de silicium.

Généralement dans l'étape b), la couche supplémentaire, ou l'ensemble de la couche supplémentaire et de la couche complémentaire éventuelle, est transformé seulement en partie en oxyde de silicium pour donner en surface une couche d'oxyde de silicium SiO₂, qui se trouve sur une couche d'épaisseur h_{z} de formule Si_{1-z}Ge_{z} dans laquelle z est, donc la valeur de concentration en germanium en amont de l'oxyde désirée pour l'application. Avantageusement, dans certains cas, z pourra tendre vers x, et même être sensiblement égal à x.

En d'autres termes, au fur et à mesure de la formation du film, de la couche de SiO₂, en surface du film supplémentaire, ladite couche étant obtenue par oxydation du silicium contenu dans la couche Si_{1-y}Ge_{y}, la composition s'enrichit en germanium dans le reste du film supplémentaire, d'épaisseur h_{z}, dont la composition moyennée sur cette épaisseur h_{z} devient Si_{1-z}Ge_{z} avec z inférieur à y.

Dans la première forme de réalisation du procédé de l'invention, il se forme à l'issue de l'oxydation comme cela est illustré sur la figure 1B une couche de SiO₂ (14) typiquement de quelques nanomètres (par exemple 2, 5, 10 nm) qui est générée dans la couche supplémentaire (13) Si_{1-y}Ge_{y}, et une couche de Si_{1-z}Ge_{z} (15) d'une épaisseur h_{z} qui est enrichi en Ge par rapport à la couche initiale supplémentaire (13).

Dans la deuxième forme de réalisation du procédé de l'invention, il se forme à l'issue de l'oxydation, comme cela est illustré sur la figure 2B, une couche de SiO₂ (24) qui est générée dans le film, couche, supplémentaire (23) Si_{1-grad y}Ge_{grad y}, et une couche enrichie en Ge (25) par rapport à la couche initiale supplémentaire (23).

Dans la troisième forme de réalisation du procédé selon l'invention, il se forme à l'issue de l'oxydation, comme cela est illustré sur la figure 3B, une couche de SiO₂ (34) qui est générée dans les films supplémentaires (33A à 33D), et une zone enrichie en Ge (35) par rapport aux plusieurs couches initiales supplémentaires (33A à 33D) (au nombre de 4 sur la figure 3A).

Dans la quatrième forme de réalisation du procédé de l'invention, il se forme à l'issue de l'oxydation, comme cela est illustré sur la figure 4B, une couche de SiO₂ (45), qui est générée dans le film complémentaire (44) (à savoir dans la totalité du film complémentaire) ou qui contient ce film complémentaire, s'il est en SiO₂, et générée également dans une partie du film supplémentaire (43), et une couche enrichie en Ge (46) par rapport à la couche initiale supplémentaire (43) .

Le procédé selon l'invention peut être intégré dans un procédé plus général dont il ne constitue alors qu'une étape.

Par exemple, le procédé selon l'invention peut être utilisé pour le transfert de film par exemple par le procédé décrit dans le brevet US 5,374,564 à la description duquel on pourra se référer.

On génère par le procédé de l'invention un oxyde thermique, futur oxyde enterré ("burried oxide" en anglais, "BOx"), de structures de type GeOI ou SiGeOI.

L'avantage apporté par le procédé de l'invention est alors d'avoir une interface Si₁₋ₓGeₓ//BOₓ de qualité électronique et d'avoir une couche de Si₁₋ₓGeₓ dont la concentration en germanium, grâce au procédé selon l'invention est la plus constante possible aux environs de cette interface.

On pourra obtenir cette structure (GeOI ou SiGeOI) à partir d'une structure obtenue par le procédé de l'invention, c'est-à-dire présentant en surface au moins un film de SiGe ou de Ge recouvert d'une couche d'oxyde (SiO₂).

On prendra soin de créer dans cette structure une zone fragile enterrée dans ce film de SiGe ou Ge, par exemple par implantation d'espèces gazeuses comme décrit dans le brevet US-A-5,374,564, l'implantation pouvant être réalisée avant ou après l'oxydation, ou même avant le dépôt de la couche supplémentaire.

La couche fragile enterrée peut ainsi être créée dans le film de SiₓGe₁₋ₓ ou dans celui de Si_{z}Ge_{1-z}. Cette structure est ensuite assemblée selon les techniques connues de l'homme du métier, par collage moléculaire, avec un substrat final, par exemple de silicium pouvant ou non être oxydé en surface. On procède alors à la dissociation de la structure ainsi obtenue au niveau de la zone fragilisée par traitement thermique et/ou mécanique. On obtient alors la structure GeOI ou SiGeOI désirée d'une part et d'autre part, une partie de la structure initiale à oxyder ou la structure à oxyder munie d'une partie de la couche Si_{1-z}Ge_{z} selon la position de la zone fragile enterrée.

Alternativement, au lieu de créer une zone fragile enterrée, on pourra procéder directement au collage moléculaire de la structure obtenue par le procédé de l'invention avec le substrat final, et procéder ensuite à l'amincissement de cette structure par voie mécanique et/ou chimique pour obtenir la structure GeOI ou SiGeOI désirée.

L'invention va maintenant être décrite en référence aux exemples suivants donnés à titre illustratif et non limitatif.

### EXEMPLE 1

Dans cet exemple, dans lequel on met en oeuvre le procédé selon l'invention, on commence par déposer des couches tampons de SiGe par des technologies diverses et connues de l'art antérieur par exemple par épitaxie en CVD ou en RPCVD, par exemple par la technique du gradient continu permettant de déposer à partir d'un substrat par exemple de silicium ("substrat initial" de silicium de 200 nm) une couche de Si₁₋ₓGeₓ dont la concentration varie continûment de 0 à la concentration désirée en surface.

On réalise ensuite, sur l'empilement de couches tampons de SiGe un film de Si_{0,7}Ge_{0,3} relaxé de 1 µm d'épaisseur par exemple par épitaxie en CVD ou en RPCVD. Puis, conformément au procédé de l'invention, on dépose sur le film de Si_{0,7}Ge_{0,3} un film supplémentaire sacrificiel et spécifique, d'environ 65 nm de Si_{0,75}Ge_{0,25} (y = 0,25) par exemple par épitaxie CVD.

On effectue ensuite un traitement thermique du film supplémentaire comprenant en particulier une oxydation par voie sèche avec du O₂ sec à un débit de 8 1/min. et à une température de 900°C.

L'oxyde SiO₂ est généré à la vitesse de 55 nm en 4 heures. La "consommation" de la couche supplémentaire pour former l'oxyde est d'environ 25 nm et la couche supplémentaire restante Si_{1-z}Ge_{z} a une épaisseur d'environ 40 nm.

L'enrichissement de cette couche supplémentaire restante en germanium est mesurée par exemple par SIMS et on établit ainsi que pour cette couche, z vaut environ 0,37.

### EXEMPLE 2

Ce deuxième exemple est une variante du premier concernant l'oxydation. Dans cet exemple, la même structure que précédemment subit une oxydation par voie humide avec de la vapeur d'eau, du H₂ à un débit de 8 1/min. et du O₂ à un débit de 4 1/min., à une température de 900°C.

L'oxyde SiO₂ est généré dans ce cas à la vitesse de 76 nm en 15 minutes. La "consommation" de la couche supplémentaire pour former l'oxyde est d'environ 35 nm et la couche supplémentaire restante de Si_{1-z}Ge_{z} a une épaisseur d'environ 30 nm, avec une concentration en germanium enrichie selon le mécanisme précédemment explicité.

## Revendications

1. Procédé de préparation d'une couche de dioxyde de silicium, par oxydation à haute température, sur un substrat massif de formule Si₁₋ₓGeₓ, dans laquelle x est supérieur à 0 et inférieur à 1 ou sur une couche de formule Si₁₋ₓGeₓ dans laquelle x est supérieur à 0 et inférieur à 1 (12, 22, 32, 42) qui se trouve elle-même déposée sur un support (11, 21, 31, 41), ledit procédé comprenant les étapes successives suivantes :
a) on dépose sur ledit substrat massif de formule Si₁₋ₓGeₓ, dans laquelle x est supérieur à 0 et inférieur à 1 ou sur ladite couche de formule Si₁₋ₓGeₓ dans laquelle x est supérieur à 0 et inférieur à 1 (12, 22, 32, 42) qui se trouve elle-même déposée sur un support (11, 21, 31, 41), au moins une couche supplémentaire (13) d'épaisseur h_{y} et de formule globale Si_{1-y}Ge_{y} dans laquelle y est supérieur à 0 et inférieur à x ;
b) on réalise l'oxydation à haute température de ladite couche supplémentaire (13) de formule globale Si_{1-y}Ge_{y}, moyennant quoi ladite couche supplémentaire (13) est transformée en totalité ou en partie en une couche d'oxyde de silicium SiO₂ (14) ; procédé dans lequel y et/ou h_{y} sont choisies, pour contrôler à l'issue de l'oxydation la concentration du germanium de la couche d'alliage SiGe se trouvant sous la couche d'oxyde de silicium; et dans lequel la composition de la couche supplémentaire (13) définie par y, et/ou l'épaisseur h_{y}, est (sont) choisie (s) en fonction du substrat massif de formule Si₁₋ₓGeₓ ou de la couche de formule Si₁₋ₓGeₓ, et/ou de l'épaisseur de la couche d'oxyde de silicium SiO₂ et/ou de la concentration en germanium de la couche d'alliage de silicium-germanium se trouvant immédiatement sous la couche d'oxyde de silicium..

2. Procédé selon la revendication 1, dans lequel le substrat est constitué par une couche de Si₁₋ₓGeₓ (12, 22, 32, 42), de préférence monocristallin sur un support (11, 21, 31 ,41), le support étant en un seul matériau tel que le germanium ou le silicium, ou comprenant un substrat de base par exemple en Si sur lequel sont réalisée(s) une ou plusieurs couche(s) tampon(s) d'adaptation par exemple en SiGe.

3. Procédé selon l'une quelconque des revendications précédentes, dans lequel la composition de la couche supplémentaire (13) définie par y, et/ou l'épaisseur h_{y}, est (sont) choisie(s) de façon à limiter les contraintes générées par la différence des mailles cristallines entre Si₁₋ₓGeₓ et Si_{1-y}Ge_{y}.

4. Procédé selon l'une quelconque des revendications précédentes, dans lequel lors de l'étape b), ladite couche supplémentaire (13), est transformée en partie en oxyde de silicium, pour donner une couche d'oxyde de silicium (14), sur une couche (15) de formule Si_{1-z}Ge_{z} et d'épaisseur h_{z}.

5. Procédé selon la revendication 4, dans lequel z est sensiblement égal à x.

6. Procédé selon l'une quelconque des revendications précédentes, dans lequel ladite couche supplémentaire (23) est une couche à gradient de composition (23) dans laquelle la concentration en germanium varie de manière continue, de préférence décroît de manière continue, à partir du substrat.

7. Procédé selon l'une quelconque des revendications précédentes, dans lequel on dépose plusieurs couches supplémentaires (33A, 33B, 33C, 33D), qui diffèrent par leur valeur de y.

8. Procédé selon la revendication 7, dans lequel la valeur de y décroît depuis la couche supplémentaire (33 A) située au voisinage du substrat jusqu'à la couche (33 D) située à l'épaisseur h_{y}.

9. Procédé selon l'une quelconque des revendications précédentes, dans lequel on dépose en outre une couche complémentaire (44) de SiGe sur ladite au moins une couche supplémentaire (43), ladite couche complémentaire (44) étant également transformée en totalité en une couche d'oxyde de silicium SiO₂ (45).

10. Procédé selon l'une quelconque des revendications 1 à 9, dans lequel on dépose en outre une couche complémentaire (44) de SiO₂ sur ladite au moins une couche supplémentaire.

11. Procédé selon l'une quelconque des revendications précédentes, dans lequel l'oxydation est une oxydation par traitement thermique oxydant réalisé par voie sèche et/ou humide.

12. Procédé de préparation d'un composant optique ou électronique comprenant au moins une étape dans laquelle on prépare une couche de dioxyde de silicium par le procédé selon l'une quelconque des revendications 1 à 11.

13. Procédé de préparation d'une structure Si_{1-X}GeₓOI dans lequel on prépare une structure comprenant un film de Si₁₋ₓGeₓ recouvert d'une couche d'oxyde de silicium SiO₂ par le procédé selon l'une quelconque des revendications 1 à 11, on fragilise, avant ou après l'étape b), une couche située au sein du film de Si₁₋ₓGeₓ par exemple par implantation d'espèces gazeuses, on assemble cette structure comprenant la couche fragilisée avec un substrat par exemple de silicium, pour obtenir un assemblage comprenant le substrat et la structure, et on dissocie cet assemblage au niveau de la couche fragilisée par un traitement thermique et/ou mécanique.

14. Procédé de préparation d'une structure Si₁₋ₓGeₓ OI dans lequel on prépare une structure comprenant un film de Si₁₋ₓGeₓ recouvert d'une couche d'oxyde de silicium SiO₂ par le procédé selon l'une quelconque des revendications 1 à 11, on assemble cette structure avec un substrat, pour obtenir un assemblage comprenant le substrat et la structure, et on procède à l'amincissement de cet assemblage par voie mécanique et/ou chimique.

## Patentansprüche

1. Verfahren zum Präparieren bzw. Realisieren einer Siliciumdioxidschicht durch Hochtemperatur-Oxidation auf einem massiven Substrat der Formel Si₁₋ₓGeₓ, bei der x größer als 0 und kleiner als 1 ist, oder auf einer Schicht der Formel Si₁₋ₓGeₓ, bei der x größer als 0 und kleiner als 1 ist (12, 22, 32, 42), die ihrerseits auf einem Träger (11, 21, 31, 41) abgeschieden ist, wobei das genannte Verfahren die folgenden aufeinanderfolgenden Schritte umfasst :
a) man scheidet auf dem genannten massiven Substrat der Formel Si₁₋ₓGeₓ, bei der x größer als 0 und kleiner als 1 ist, oder auf einer Schicht (12, 22, 32, 42) der Formel Si₁₋ₓGeₓ, bei der x größer als 0 und kleiner als 1 ist, die ihrerseits auf einem Träger (11, 21, 31, 41) abgeschieden ist, wenigstens eine Zusatzschicht (13) mit der Dicke h_{y} und der globalen Formel Si₁₋ₓGe_{y} ab, bei der y größer als 0 und kleiner als x ist;
b) man führt die Hochtemperatur-Oxidation der genannten Zusatzschicht (13) der globalen Formel Si_{1-y}Ge_{y} durch, mittels der die genannte Zusatzschicht (13) ganz oder teilweise in eine SiO₂-Siliciumoxidschicht (14) umgewandelt wird; wobei in diesem Verfahren y und/oder h_{y} gewählt werden, um am Ende der Oxidation die Konzentration des Germaniums der SiGe-Legierungsschicht zu steuern, die sich unter der SiO₂-Siliciumoxidschicht befindet; und bei dem die Zusammensetzung der Zusatzschicht (13), definiert durch y, oder/und die Dicke h_{y} in Abhängigkeit von dem massiven Substrat der Formel Si₁₋ₓGeₓ oder von der Schicht der Formel Si₁₋ₓGeₓ , oder/und von der Dicke der SiO₂-Schicht oder/und von der Germaniumkonzentration der Silicium-Germaniumlegierungsschicht ausgewählt wird (werden), die sich unmittelbar unter der SiO₂-Siliciumoxidschicht befindet.

2. Verfahren nach Anspruch 1, bei dem das Substrat durch eine vorzugsweise monokristalline Si₁₋ₓGeₓ-Schicht (12, 22, 32, 42) auf einem Träger (11, 21, 31, 41) ausgebildet wird, wobei der Träger aus einem einzigen Material wie etwa Germanium oder Silicium ist, oder ein Basissubstrat umfasst, zum Beispiel aus Si, auf dem eine (oder mehrere) Pufferanpassungsschicht(en), zum Beispiel aus SiGe, realisiert sind.

3. Verfahren nach einem der vorhergehenden Ansprüche, bei dem die Zusammensetzung der Zusatzschicht (13), definiert durch y, und/oder die Dicke h_{y} ausgewählt wird (werden), um die durch die Kristallmaschendifferenzen erzeugten Spannungen zwischen Si₁₋ₓGeₓ und Si_{1-y}Ge_{y} zu begrenzen.

4. Verfahren nach einem der vorhergehenden Ansprüche, bei dem in Schritt b) die genannte Zusatzschicht (13) teilweise in Siliciumoxid umgewandelt wird, um eine Siliciumoxidschicht (14) zu erhalten, auf einer Schicht (15) der Formel Si_{1-z}Ge_{z} und der Dicke h_{z}.

5. Verfahren nach Anspruch 4, bei dem z im Wesentlichen gleich x ist.

6. Verfahren nach einem der vorhergehenden Ansprüche, bei dem die genannte Zusatzschicht (23) eine Schicht mit einem Zusammensetzungsgradienten ist und bei der die Germaniumkonzentration kontinuierlich variiert, vorzugsweise kontinuierlich abnimmt, ab dem Substrat.

7. Verfahren nach einem der vorhergehenden Ansprüche, bei dem man mehrere Zusatzschichten (33A, 33B, 33C, 33D) abscheidet, die sich durch ihren y-Wert unterscheiden.

8. Verfahren nach Anspruch 7, bei dem der y-Wert ab der Zusatzschicht (33A), die sich in der Nähe bzw. neben dem Substrat befindet, bis hin zu der die Dicke h_{y} begrenzenden Schicht (33D) abnimmt.

9. Verfahren nach einem der vorhergehenden Ansprüche, bei dem man außerdem auf der genannten wenigstens einen Zusatzschicht (43) eine SiGe-Zusatzschicht (44) abscheidet, wobei die genannte Zusatzschicht (44) ebenfalls gänzlich in eine SiO₂-Siliciumoxidschicht (45) umgewandelt wird.

10. Verfahren nach einem der Ansprüche 1 bis 9, bei dem man außerdem eine SiO₂-Zusatzschicht (44) auf der genannten wenigstens einen Zusatzschicht abscheidet.

11. Verfahren nach einem der vorhergehenden Ansprüche, bei dem die Oxidation eine Oxidation durch oxidierende Wärmebehandlung der trockenen oder nassen Art ist.

12. Verfahren zum Präparieren bzw. Realisieren eines optischen oder elektronischen Bauteils, wenigstens einen Schritt umfassend, bei dem man eine Siliciumdioxidschicht durch ein Verfahren nach einem der Ansprüche 1 bis 11 realisiert.

13. Verfahren zum Realisieren einer Si₁₋ₓGeₓOl-Struktur, bei der man eine Struktur realisiert die einen Si₁₋ₓGeₓ-Film umfasst, überzogen mit einer SiO₂-Siliciumoxidschicht gemäß dem Verfahren nach einem der Ansprüche 1 bis 11, man vor oder nach dem Schritt b) eine Schicht schwächt, die sich in dem Si₁₋ₓGeₓ-Film befindet, zum Beispiel durch Implantation von gasförmigen Spezies, man diese die geschwächte Schicht enthaltende Struktur mit einem Substrat zum Beispiel einem Siliciumsubstrat zusammenbaut, um einen das Substrat und die Struktur umfassenden Zusammenbau zu erhalten, und man diesen Zusammenbau in Höhe der geschwächten Schicht durch eine thermische und/oder mechanische Behandlung trennt.

14. Verfahren zum Realisieren einer Si₁₋ₓGeₓ Ol-Struktur, bei der man eine Struktur realisiert die einen Si₁₋ₓGeₓ-Film umfasst, überzogen mit einer SiO₂-Siliciumoxidschicht gemäß dem Verfahren nach einem der Ansprüche 1 bis 11, man diese Struktur mit einem Substrat zusammenbaut, um einen das Substrat und die Struktur umfassenden Zusammenbau zu erhalten, und man diesen Verbund auf mechanischem und/oder chemischem Wege dünner macht.

## Claims

1. Method of producing a silicon dioxide layer by high-temperature oxidation on a solid substrate of formula Si₁₋ₓGeₓ wherein x is greater than 0 and less than 1, or on a layer of formula Si₁₋ₓGeₓ wherein x is greater than 0 and less than 1 (12, 22, 32, 42), said layer being itself deposited on a support (11, 21, 31, 41), the said method comprising the following successive steps:
a) at least one additional layer (13) of thickness h_{y} and of overall formula Si_{1-y}Ge_{y}, in which y is greater than 0 and less than x, is deposited on the said solid substrate of formula Si₁₋ₓGeₓ wherein x is greater than 0 and less than 1 or on said layer of formula Si₁₋ₓGeₓ wherein x is greater than 0 and less than 1 (12, 22, 32, 42), said layer being itself deposited on a support (11, 21, 31, 41);
b) the high-temperature oxidation of the said additional layer (13) of overall formula Si_{1-y}Ge_{y} is carried out, whereby the said additional layer (13) is completely or partly converted into a layer of silicon oxide SiO₂ (14); method wherein y and/or h_{y} are chosen so as to control, after the oxidation, the germanium concentration of the SiGe alloy layer lying below the silicon oxide layer; and wherein the composition of the additional layer (13) defined by y and/or the thickness h_{y} is(are) chosen according to the solid substrate of formula Si₁₋ₓGeₓ or to the layer of formula Si₁₋ₓGeₓ and/or according to the thickness of the layer of silicon oxide SiO₂ and/or to the germanium concentration of the silicon-germanium alloy layer lying immediately below the silicon oxide layer.

2. Method according to Claim 1, wherein the substrate is composed of a, preferably single-crystal, Si₁₋ₓGeₓ layer (12, 22, 32, 42) on a support (11, 21, 31, 41), the support being made of a single material, such as germanium or silicon, or comprising a base substrate, for example made of Si, on which one or more buffer matching layer(s), for example made of SiGe, is(are) produced.

3. Method according to any one of the preceding claims, wherein the composition of the additional layer (13) defined by y and/or the thickness h_{y} is(are) chosen so as to limit the stresses generated by the difference in crystal lattice parameters between Si₁₋ₓGeₓ and Si_{1-y}Ge_{y}.

4. Method according to any one of the preceding claims, wherein during step b), the said additional layer (13) is partly converted into silicon oxide in order to give a silicon oxide layer (14) on a layer of formula Si_{1-z}Ge_{z} (15) and of a thickness h_{z}.

5. Method according to Claim 4, wherein z is substantially equal to x.

6. Method according to any one of the preceding claims, wherein the said additional layer (23) is a graded composition layer (23) in which the germanium concentration varies continuously, preferably continuously decreases, from the substrate.

7. Method according to any one of the preceding claims, wherein several additional layers (33A, 33B, 33C, 33D) are deposited, which differ in their value of y.

8. Method according to Claim 7, wherein the value of y decreases from the additional layer (33A) located near the substrate as far as the layer (33D) located at the thickness h_{y}.

9. Method according to any one of the preceding claims, wherein a complementary layer (44) of SiGe is also deposited on the said at least one additional layer (43), the said complementary layer (44) also being completely converted into a layer of silicon oxide SiO₂ (45).

10. Method according to any one of Claims 1 to 9, wherein a complementary SiO₂ layer (44) is also deposited on the said at least one additional layer.

11. Method according to any one of the preceding claims, wherein the oxidation is an oxidation by oxidizing heat treatment carried out dry and/or wet.

12. Method of producing an optical or electronic component, comprising at least one step wherein a layer of silicon dioxide is prepared by the method according to any one of Claims 1 to 11.

13. Method of producing an Si₁₋ₓGeₓOl structure wherein a structure comprising an Si₁₋ₓGeₓ film covered with a layer of silicon oxide SiO₂ is prepared by the method according to any one of Claims 1 to 11, a layer located within the Si₁₋ₓGeₓ film is weakened, before or after step b), for example by the implantation of gaseous species, this structure comprising the weakened layer is joined to a substrate, for example a silicon substrate, in order to obtain an assembly comprising the substrate and the structure, and this assembly is separated at the weakened layer by a heat and/or mechanical treatment.

14. Method of producing an Si₁₋ₓGeₓOl structure wherein a structure comprising an Si₁₋ₓGeₓ film covered with a layer of silicon oxide SiO₂ is prepared by the method according to any one of Claims 1 to 11, this structure is joined to a substrate, in order to obtain an assembly comprising the substrate and the structure, and this assembly is mechanically and/or chemically thinned.
